# EUROPÄISCHE PATENTSCHRIFT

(11) **EP 1 179 139 B1**
(45) Veröffentlichungstag und Bekanntmachung des Hinweises auf die Patenterteilung: **13.08.2003**
(21) Anmeldenummer: 00943563.7
(22) Anmeldetag: 05.05.2000
(51) Int. Cl.: F04B 43/04, F04B 43/12

(54) **MIKROMECHANISCHE PUMPE**
MICROMECHANIC PUMP
POMPE MICROMECANIQUE

(30) Priorität: 17.05.1999 DE 19922612; 07.04.2000 DE 10017164
(43) Veröffentlichungstag der Anmeldung: 13.02.2002
(73) Patentinhaber: Fraunhofer-Gesellschaft zur Förderung der angewandten Forschung e.V., 80636 München (DE)
(72) Erfinder: LISEC, Thomas, D-20255 Hamburg (DE); WAGNER, Bernd, D-25582 Looft (DE)
(86) Internationale Anmeldenummer: DE0001429
(87) Internationale Veröffentlichungsnummer: WO00070224

(56) Entgegenhaltungen:
- EP-A- 0 439 327
- EP-A- 0 518 524
- WO-A-95/18307
- WO-A-97/29538
- DE-A- 19 719 862
- DE-U- 9 209 402
- US-A- 5 705 018

## Beschreibung

Die Erfindung betrifft eine mikromechanische Pumpe, mit einem peristaitischen Aktuator zur Förderung und/oder Verwaltung definierter Flüssigkeits- oder Gasmengen (Pumpmedium).

Das Dosieren geringster Flüssigkeitsmengen im Mikro- bis Nanoliter Bereich wird für viele Anwendungen in der Analytik, der Medizin- oder Umwelttechnik immer relevanter. Oftmals ist es von Interesse, eine definierte Flüssigkeitsmenge an einer Stelle aufzunehmen, zu transportieren und an einer anderen Stelle abzugeben. Aufgaben dieser Art sind Bestandteil aller quantitativer Analysen. Moderne Geräte können mittels schrittmotorgesteuerter Spritzenpumpen und Präzisionspipetten einige zehn bis einige hundert Mikroliter einer Flüssigkeit mit einer Genauigkeit besser als ein Prozent dosieren. Um Mengen von einigen hundert Nanolitem bis einigen zehn Mikrolitern mit derselben Genauigkeit zu manipulieren, müssen jedoch andere Dosierkonzepte gefunden werden.

### Stand der Technik

Bei Dosiersystemen, die auf Mikropumpen beruhen, dominieren zwei Konzepte. Zum einen kommen Membranpumpen mit zwei passiven Ventilen zum Einsatz, zum anderen ventillose Pumpen nach dem Diffuser-Nozzle-Prinzip, welche im Ruhezustand nicht dicht sind. Beide Typen sind uni-direktional, d. h. sie können nur in einer Richtung fördern. Als Antrieb werden in beiden Fällen üblicherweise Piezoaktoren eingesetzt, die man auf die Pumpmembran aufklebt.
Eine elektrostatisch angetriebene Mikromembranpumpe mit passiven Ventilen ist aus DE 19719862 bekannt. Bei hohen Antriebsfrequenzen dreht sich die Förderrichtung dieser Pumpe aufgrund der Trägheit der passiven Ventile um. Diese Eigenschaft ist jedoch nur begrenzt zum Rückwärtspumpen nutzbar. Die Förderrate ist nicht nur von der zugeführten Leistung, sondern auch von den Eigenschaften des zu fördernden Pumpmediums abhängig. Es ist daher nicht möglich, von der eingebrachten elektrischen Leistung auf den Durchfluß eines beliebigen Pumpmediums zu schließen. Da das bei jedem Pumpschlag verdrängte Volumen nur einen Bruchteil des Volumens der Pumpkammer beträgt, hat die Pumpe ein hohes Totvolumen.

Die US 57 05 018 offenbart eine mikromechanische peristaltische Pumpe bei der das zu pumpende Medium mittels einer elektrisch leitfähigen Membran in einer mit Elektroden ausgestatteten Kavität befördert wird. Diese Pumpe hat den Nachteil, das sie im Ruhezustand nicht dichtet und dass die Spannung zwischen Membran und Elektroden über dem zu pumpenden Medium abfällt. Pumpen mit einem kreisförmigen Antriebselement werden z.B. in der WO 98/07199 offenbart.

Das Prinzip einer pneumatischen Kopplung abgeschlossener Luftvolumina für ein Mikroventil ist aus der Offenlegungsschrift DE 196 37 928 A1 bekannt. Dort ist ebenfalls eine auf diesem Prinzip basierende Mikropumpenanordnung offenbart. Nachteil dieser Anordnung ist, daß die Membran nicht fest an den Deckel abschließt. Dadurch werden zusätzliche Ventile benötigt um die Dichtheit der Pumpe im Ruhezustand zu gewährleisten. Weiter kann aufgrund der nicht endlos zusammenhängenden Form des Förderkanals kein ununterbrochen kontinuierlicher Pumpmedientransport erfolgen. Diese Nachteile wirken sich negativ auf die Genauigkeit der Dosierfähigkeit und auf die Förderfähigkeit der Pumpe aus.

Zusammenfassend kann festgestellt werden, daß es keinen Ansatz für Dosiersysteme gibt, die eine vorgegebene Flüssigkeitsmenge an einer Stelle aufnehmen und an einer-anderen wieder abgeben können. Mikropumpen, die Flüssigkeitsmengen im Bereich unter zehn Mikrolitern präzise dosieren können, sind ebenfalls nicht verfügbar.

### Gelöste Aufgabe

Der Erfindung liegt die Aufgabe zugrunde eine bidirektionale Mikropumpe zu schaffen, welche in der Lage ist im Mikroliterbereich, sowohl kontinuierlich zu fördern, als auch definierte Flüssigkeitsvolumina zu verwalten.

### Beschreibung

Gemäß der vorliegenden Erfindung wird die Aufgabe durch die Merkmale des Anspruches 1 gelöst. Die vorliegende Erfindung stellt darüber hinaus in den Ansprüchen 11 bis 14 auch Verfahren zum Betreiben der Pumpe zur Verfügung.

Die bevorzugten Ausführungsformen sind Gegenstand der abhängigen Ansprüche.

Die mikromechanische Pumpe beruht auf dem Prinzip eines peristaltischen Aktuators, welcher durch das dichtende Überspannen, eines mit einem Antriebsmedium gefüllten, linear endlos zusammenhängenden, bevorzugt ringförmigen Hohlraumes in einem Substrat (Kavität), mit einer elektrisch leitfähigen Membran gebildet wird. Auf dem Boden des Hohlraumes sind zumindest teilweise getrennt ansteuerbare Elektroden fest installiert. Bei teilweiser Ansteuerung der Elektroden wird die Membran über den angesteuerten Elektroden nach unten gezogen und, durch die Verdrängung des Antriebsmediums, die Membran über den nicht angesteuerten Elektroden nach oben gedrückt. Die Elektroden müssen dabei mit einer passivierenden Schicht von der Membran getrennt sein, damit im angesteuerten Zustand kein Kurzschluss zwischen den Elektroden und der Membran entstehen kann. Diese Schicht wird bevorzugt auf der Unterseite der Membran aufgebracht und besteht bei einer Membran aus Silizium bevorzugt aus Siliziumoxid.
Da die Kavität abgeschlossen ist, d.h. einen Hohlraum mit einem festen Volumen bildet und dieser Hohlraum das Antriebsmedium beinhaltet, muss die Membran, bedingt durch die Verdrängung des Antriebsmediums aus den Bereichen der Kavität in denen die Membran nach unten gezogen ist, an den Stellen, wo die Elektroden nicht angesteuert sind nach oben herausbuckeln. Werden ausreichend viele Elektroden angesteuert, wird das Antriebsmedium unter den nach oben herausgewölbten Membranbereichen derart komprimiert, dass die herausgebuckelten Bereiche fest an den Deckel gepresst werden. Dieser Effekt wird als pneumatische Kopplung bezeichnet. Indem die Elektroden auf geeignete Weise paarweise neben den herausgebuckelten Bereichen angesteuert werden, können die herausgebuckelten Bereiche über der Kavität verschoben werden. Die Ansteuerung der Elektroden wird dazu in Pumprichtung jeweils hinter der Ausbuckelung abgeschaltet und davor eingeschaltet. Es handelt sich also um einen indirekten Antrieb. Das Pumpmedium wird nicht unmittelbar durch das Ansteuern der Elektroden, sondern durch das Verschieben eines oder mehrerer herausgebuckelter Bereiche, unter denen das Antriebsmedium komprimiert ist, in Pumprichtung verdrängt. Das Antriebsmedium kann aus einer Flüssigkeit oder einem Gas bestehen. Handelt es sich um eine Flüssigkeit, so muss das Volumen der Flüssigkeitsmenge kleiner als das Volumen der Kavität sein. Aufgrund der Inkompressibilität von Flüssigkeiten kann sonst die Membran nicht nach unten buckeln. Bedingt durch das geringere Flüssigkeitsvolumen wird die Membran schon im nicht angesteuerten Zustand nach unten gebuckelt. Gleiches wird erreicht, wenn bei einem Gas als Antriebsmedium ein Unterdruck im Hohlraum der von der Membran abgedeckten Kavität besteht.
Besonders vorteilhaft ist es, im Fall eines Unterdruckes des Antriebsmediums oder im Fall einer Flüssigkeit als Antriebsmedium, wenn die Membran unter einer Druckspannung steht, so dass sie bereits ohne das Ansteuern der Elektroden von selbst einen ausgebuckelten Bereich ausbildet (spontanes Buckeln). Dies kann z.B. bei einer Siliziummembran durch das Aufoxidieren einer Siliziumoxidschicht erreicht werden. Eine derartige Membran hat die Eigenschaft, dass sie über der Kavität in einigen Bereichen nach unten und in anderen Bereichen nach oben ausbuckelt. Die erfindungsgemäße Pumpe hält dadurch ihren zuletzt durch Ansteuerung von Elektroden eingenommenen Zustand, auch wenn die Ansteuerung der Elektroden abgeschaltet wird. Im leistungslosen, d.h. nicht angesteuerten Zustand kann im Fall des spontanen Buckelns der Membran das Pumpmedium nicht durch die Pumpe fließen. Im Idealfall ist die spontane Buckelung in Verbindung mit dem Unterdruck oder dem festen Flüssigkeitsvolumen in der Kavität derart ausgeprägt, dass sich eine gewünschte Anzahl von Verschlüssen ergeben, welche gerade ausreichend breit sind um die Einlässe bzw. Auslässe der Pumpe jeweils zu überdecken.
Um eine Pumpe zu erhalten wird das Antriebselement, d. h. die Membran, mit einem flachen Deckel, der Einlaß und Auslass enthält, fest abgedeckt. In den Bereichen der angesteuerten Elektroden, wo die Membran nach unten gezogen wird, entsteht ein Spalt zwischen Deckel und Membran, wogegen in den Bereichen der nicht angesteuerten Elektroden die Membran an den Deckel gedrückt wird. Dieser Spalt dient zur Aufnahme des Pumpmediums. Durch gezieltes Ansteuern der Elektroden kann der Bereich, in welchem die Membran an den Deckel gedrückt wird, peristaltisch vom Einlaß zum Auslass bewegt werden. Das im Spalt eingeschlossene Pumpmedium wird definiert befördert. Der Deckel kann jedoch auch eine der Kavität ähnliche, eingekerbte Oberfläche über der Kavität, also einen Durchgang, aufweisen. Aufgrund des in den herausgebuckelten Membranbereichen, durch die pneumatische Kopplung, hohen Anpressdruckes der Membran an den Deckel kann sich der gebuckelte Bereich im Rahmen der Elastizität der Membran an die Form des Durchganges anpassen.

Besonders vorteilhaft ist die linear endlos zusammenhängende, bevorzugt ringförmige Form der Kavität, falls die Querschnittsform der Kavität der Form der nach unten ausgebuckelten Membran entspricht und die Elektrodenform ebenfalls derart gekrümmt ist. In diesem Fall lässt sich, auch wenn die Membran, im angesteuerten Zustand dicht an das Substrat anliegt und das Antriebsmedium daher nur in Pumprichtung verdrängt werden kann, ein kontinuierlicher Pumpprozess aufrecht erhalten. Dies wäre im Fall einer nicht endlos zusammenhängenden Kavität nicht möglich, da dann die Ansteuerung der Elektroden derart erfolgen müsste, dass das Antriebsmedium für den nächsten Pumpzyklus wieder zum Einlass verdrängt werden müsste.
Die an die nach unten ausgebuckelte Membran angepasste Querschnittsform der Kavität ist besonders vorteilhaft, falls es sich bei dem Antriebsmedium um ein Gas handelt, da dann der Druckanstieg im Gas, wegen dessen geringerem Volumen, bei Ansteuerung von Elektroden besonders hoch ist und die Membran in den nicht angesteuerten Bereichen fester an den Deckel gepresst wird und daher die Pumpe dichter schließt. Was besonders bei der Benutzung als Ventil von großem Vorteil ist.
Die Pumpe ist bi-direktional, d. h. es besteht die Möglichkeit die Pumprichtung jederzeit umzudrehen, und hat ein geringes Totvolumen, was beim Pumpen kompressibler Medien, also Gasen, von entscheidendem Vorteil ist. Saug- und Pumpdruck der erfindungsgemäßen Pumpe sind in etwa gleich groß, da die Buckel aus komprimiertem Gas oder dem festgelegten Volumen der Antriebsmediumsflüssigkeit in ihrer Form auf allen Seiten durch die angesteuerten Elektroden festgelegt sind. Der Antrieb kann mediengetrennt erfolgen, d. h. die Elektroden kommen nicht mit dem Pumpmedium in Berührung, insbesondere muss die Spannung zwischen angesteuerten Elektroden und Membran nicht unmittelbar über dem Pumpmedium abfallen.
Da sich die Kapazität zwischen einzelnen Elektroden und der Membran in den herausgewölbten, erheblich von der Kapazität in den unten anliegenden Bereichen unterscheidet, kann der Pumpvorgang elektronisch überwacht werden. Eine gesteuerte Dosierung geringster Flüssigkeitsmengen ist möglich.
Ein weiterer Vorteil ist es, wenn die Membran unter Druckspannung steht, d. h. in Teilbereichen ohne jede Ansteuerung buckelt (spontanes Buckeln) , so dass, wegen der weniger notwendigen Dehnung der Membran, weniger Kraft aufgewendet werden muss, um als Verschluss dienende herausgewölbte Bereiche innerhalb der Kavität zu bewegen. Das Ausbilden definierter Buckel benötigt bei unter Druckspannung stehender Membran weniger Kraft, da bereits Teilbereiche der Membran nach unten ausgebuckelt sind und somit in diesen Bereichen keine Kraft zum Anspannen der Membran in Richtung Kavität aufgebracht werden muss. Die Pumpe kann dann mit wesentlich geringerer Spannung betrieben werden und es entsteht ein bistabiles Ventil , dessen Schaltzustände leistungslos gehalten werden können.

Die vorliegende Erfindung wird ohne Beschränkung des allgemeinen Erfindungsgedankens im Folgenden anhand von Ausführungsbeispielen unter Bezugnahme auf die Zeichnungen beschrieben.
Fig. 1 zeigt das Antriebselement der Mikropumpe im Querschnitt (Fig. 1a) und in der Draufsicht (Fig. 1b).
Fig. 2 zeigt die erfindungsgemäße Pumpe, bestehend aus dem Antriebselement und einem Deckel mit Einlass und Auslass.
Fig. 3 zeigt die Ausbildung von zwei Kanälen für das Pumpmedium durch Ausbildung von zwei Verschlüssen.
Fig. 4 veranschaulicht den Pumpprozess durch eine systematische Darstellung verschiedener Positionen der Verschlüsse während der Pumpzyklen.
Fig. 5 zeigt den Querschnitt des Kanals für das Pumpmedium bei angesteuerten Elektroden.
Fig. 6 zeigt zwei weitere Ausführungsformen der erfindungsgemäßen Pumpe.
Fig. 7 zeigt ein, durch das Vorhandensein zweier Auslässe an der erfindungsgemäßen Pumpe gebildetes Ventil.
Fig. 8 veranschaulicht den Herstellungsprozess der Pumpe.

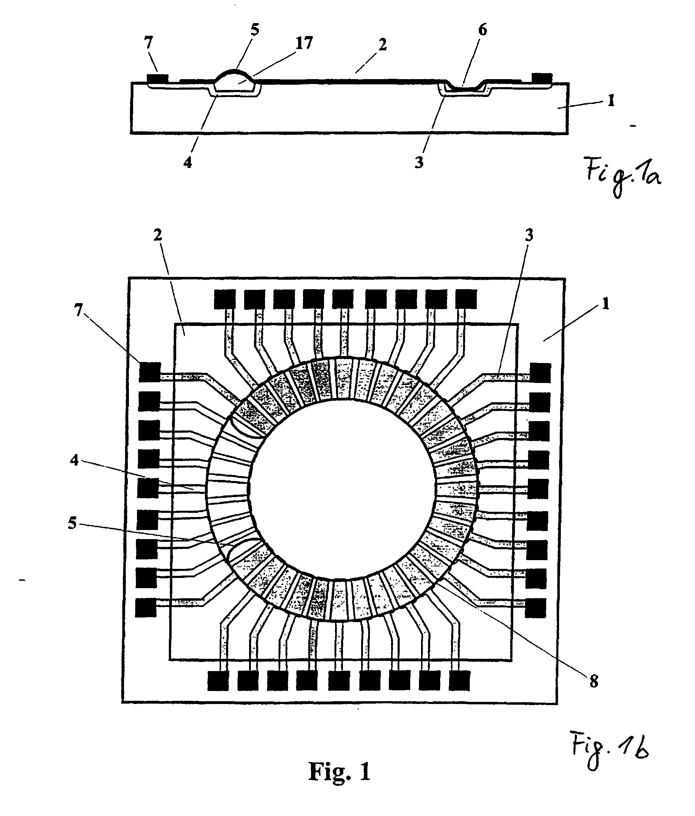

Fig. 1 zeigt das Antriebselement der Mikropumpe als einen peristaltischen Aktuator, der ähnlich einer Schlauchpumpe funktioniert, als Querschnitt durch den peristaltischen Pumpenaktuator und als Draufsicht. Eine linear endlos zusammenhängende, bevorzugt ringförmige Einkerbung (8) mit beliebigem Querschnitt (Kavität) in einer Substratoberfläche wird von einer Membran (2) überspannt. Erfolgt der Verbindungsprozeß von Substrat (1) und Membran unter Normaldruck z. B. an Luft, wird ein bestimmtes Luftvolumen in der Kavität eingeschlossen. Der Pumpenaktuator wird also durch einen abgeschlossenen Hohlraum beliebiger Form zwischen einer beweglichen Membran und einem festen Untergrund gebildet. Dieser Hohlraum ist mit einem Gas oder einer Flüssigkeit (Antriebsmedium (17)), z. B. Luft gefüllt. Besteht das Antriebsmedium aus einer inkompressiblen Flüssigkeit, so ist die Anzahl der ansteuerbaren Elektroden durch das eingeschlossene Flüssigkeitsvolumen festgelegt. Die Membran ist elektrisch leitfähig oder/und leitfähig beschichtet. Sie kann z. B. aus-Silizium, Metall oder Kunststoff bestehen. Das Substrat kann aus einem beliebigen, festen Material bestehen. Auf dem Boden der Kavität sind mehrere, voneinander isolierte Elektroden (3, 4) vergraben, welche zumindest teilweise unabhängig voneinander ansteuerbar sind. Die Elektroden können z. B. in Silizium implantiert sein, d.h. aus dotierten Bereichen im Substrat bestehen oder eine metallische Dünnschicht auf einem Isolator, wie Glas, Kunststoff oder Keramik darstellen. Für jede getrennt ansteuerbare Elektrode wird ein Kontakt-Pad (7) bereitgestellt. Wird eine elektrische Spannung zwischen Membran und einer oder mehreren der Elektroden angelegt, zieht es die Membran an diesen Stellen nach unten (6). Da das Volumen unterhalb der Membran abgeschlossen ist, führt die verdrängte Luft, im Allgemeinen das Antriebsmedium, zu einem Ausbuckeln der Membran an einer anderen Stelle nach oben (5). Steuert man die Elektroden in einer geeigneten Weise an, kann der Buckel peristaltisch entlang der Kavität, also bei der bevorzugten Kreisform, im Kreis bewegt werden. Auf der linken Seite der Draufsicht ist ein Teil der Elektroden nicht angesteuert (4), d. h. nicht unter Spannung, die Membran kann sich hier unter dem Druck des eingeschlossenen Antriebsmediums nach oben buckeln.
Fig: 2 zeigt, wie um eine Pumpe zu erhalten, das Antriebselement, d. h. die Membran, mit einem flachen Substratdeckel (9) z. B. aus Silizium, Glas, Metall, Keramik oder Kunststoff, der den Einlaß (11) und den Auslaß (10) der Pumpe enthält, fest abgedeckt wird. Dies geschieht z. B. durch Aufbonden des Deckels. Durch spezielle Maßnahmen, wie z. B. das Aufbringen einer nicht bondbaren Beschichtung, wird verhindert, daß die Membran (2) im Kanalbereich am Deckel anklebt. Wird nun ein Teil der Elektroden angesteuert und die Membran dadurch nach unten gezogen, entsteht an dieser/n Stelle/n zwischen Membran und Deckelsubstrat ein Kanal. Durch den Einlaß kann sich der Kanal mit einem Pumpmedium (12) füllen. An anderer/n Stelle/n, wo keine Spannung anliegt, preßt das verdrängte Antriebsmedium die Membran an das Deckelsubstrat. Es bildet sich ein Verschluß.

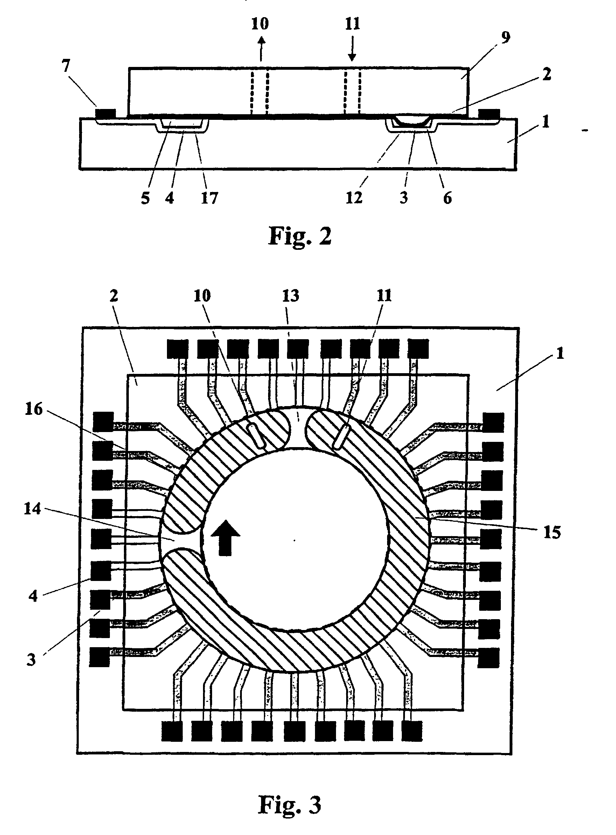

Fig. 3 zeigt, wie durch geeignete Ansteuerung der Elektroden zwei Kanäle (15, 16), abgetrennt durch zwei dieser Verschlüsse (13, 14), ausgebildet werden können. Wird Verschluß 1 (13) zwischen Einlaß (11) und Auslaß (10) positioniert und Verschluß 2 (14) bewegt, wird die Flüssigkeit aus Kanal 1 (16) in den Auslaß verdrängt und in Kanal 2 (15) Flüssigkeit angesaugt. Hat Verschluß 2 den Auslaß erreicht, werden beide Verschlüsse synchron weiterbewegt, bis Verschluß 2 die Position zwischen den Öffnungen erreicht hat. Dann beginnt ein neuer Pumpzyklus mit Verschluß 1 in der Kolbenfunktion. Die Breite der Verschlüsse und der Öffnungen muß so gewählt werden, daß es zu keinem Kurzschluß zwischen Ein- und Auslaß kommen kann.

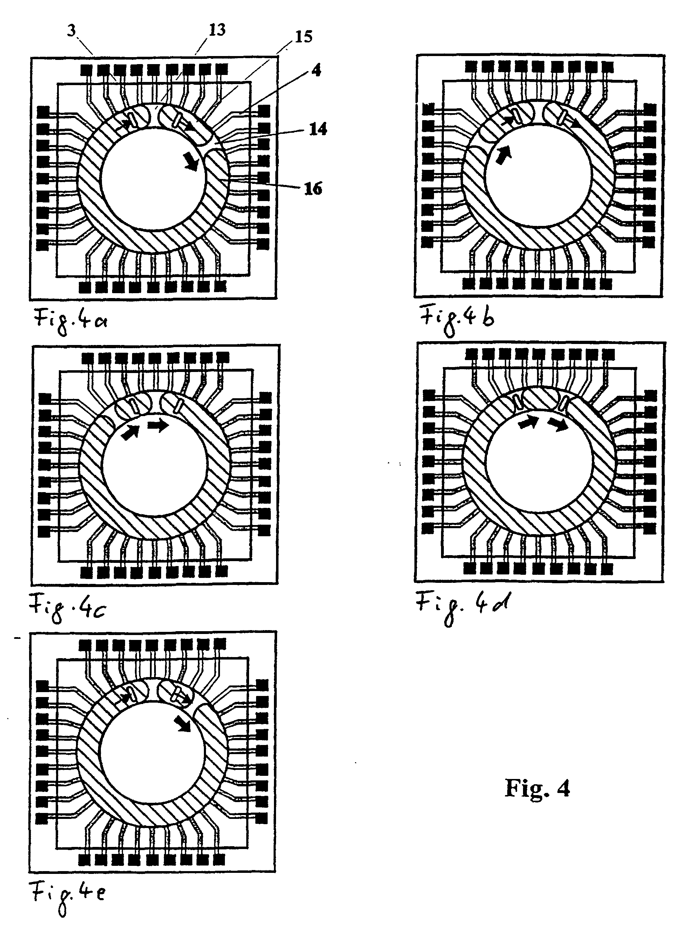

Fig. 4 veranschaulicht den Pumpprozeß durch eine systematische Darstellung eines Pumpzyklus. Wird z. B. Verschluß 1 zwischen Ein- und Auslaß positioniert und Verschluß 2 bewegt, wird das zu pumpende Medium aus Kanal 1 in den Auslaß verdrängt und gleichzeitig vom zu pumpenden Medium aus dem Einlaß in Kanal 2 angesaugt (Fig. 4a, 4b). Erreicht Verschluß 2 den Auslaß, wird Verschluß 1 syncron dazu weitergeschoben (Fig. 4c, 4d). Die Verschlüsse tauschen die Funktion, Verschluß 2 bleibt stehen, Verschluß 1 wandert, d. h. es beginnt ein neuer Pumpzyklus (Fig. 4e). Die Pumprichtung ist frei wählbar, sie wird durch die Ansteuerung der vergrabenen Elektroden vorgegeben.

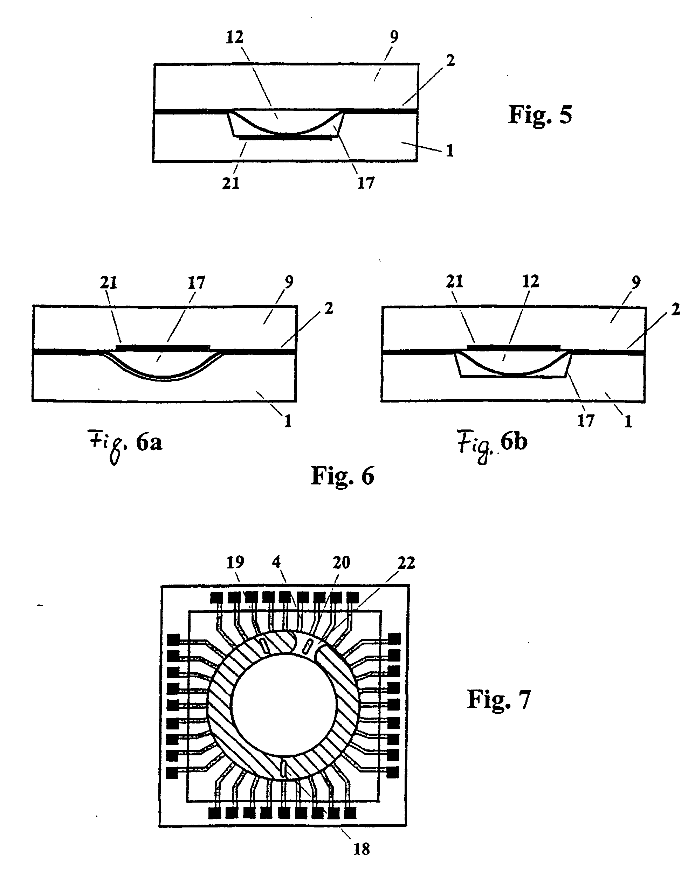

Fig. 5 zeigt die Pumpenstruktur, gebildet durch eine abgeschlossene, mit Antriebsmedium, z.B. einem Gas (17) gefüllte Kavität mit innenliegenden, getrennt ansteuerbaren Elektroden (21). Dieses Array elektrisch getrennt ansteuerbarer Elektroden befindet sich innerhalb des Hohlraums. Die Elektroden sind fest auf dem Untergrund (Substrat (1)) fixiert. Das zu fördernde Pumpmedium (12) befindet sich zwischen Membran (2) und Deckel (9). Wird zwischen ausgewählten Elektroden und der Membran eine elektrische Spannung angelegt, wird die Membran in diesem Bereich auf den Boden der Kavität heruntergezogen. Da die Kavität z. B. gasgefüllt ist, wird die Membran in den nicht angesteuerten Bereichen herausgewölbt (pneumatische Kopplung). Die Membran dichtet in den herausgewölbten Bereichen gegen die ebene oder z. B. gekrümmte Fläche eines starren Deckels. In den angesteuerten Bereichen besteht dagegen zwischen Membran und Deckel ein Spalt. Dadurch kann ein zwischen Membran und Deckel befindliches Pumpmedium definiert bewegt werden. Fig. 6 zeigt zwei weitere Ausführungsform der beschriebenen Erfindung. In Fig. 6a befindet sich das Elektrodenarray (21) auf der Unterseite des Deckels (9). Dadurch wird der abgeschlossene, mit Antriebsmedium (17) gefüllte Aktuatorhohlraum zwischen Deckel und Membran (2) gebildet. Das zu fördernde Pumpmedium (12) befindet sich zwischen Membran (2) und Substrat (1). Das Substrat (1) muß dann entsprechend ausgeformt sein, damit die Membran dagegen dicht schließt. In Fig. 6b liegt das Elektrodenarray (21) außerhalb der mit dem Antriebsmedium (17) gefüllten Kavität, welche zwischen Membran (2) und Substrat (1) gebildet wird, an der Unterseite des Deckels (9). Dann fällt die elektrische Antriebsspannung über dem zu fördernden Pumpmedium (12) ab.
Fig. 7 zeigt ein Ventil auf der Grundlage der in Fig. 5 dargestellten Pumpenstruktur mit einem Ein- (11) und zwei Auslässen (101, 102). Das Abdichten des rechten Auslasses (102) erfolgt dabei analog zur Pumpe durch Herausbildung eines Verschlusses (22) unterhalb dieser Öffnung, in dem die Membran in allen Bereichen außerhalb der Öffnung durch Ansteuern der entsprechenden Elektrode nach unten gezogen wird. Die Elektroden (4) unterhalb der Öffnung (Auslaß (102)) werden hingegen nicht angesteuert, so daß die Membran an dieser Stelle gegen den Deckel gedrückt wird und die Öffnung (Auslaß (102)) verschließt. Damit dies möglich wird, muß die Öffnung entsprechend dimensioniert sein. Hat der Deckel mehrere Zuund/oder Abführungen für Gase oder Flüssigkeiten, die sich durch eine geeignete Ansteuerung der Elektroden unabhängig voneinander verschließen oder öffnen lassen, so kann z. B. ein Ventil mit mehreren Ein- und/oder Auslässen realisiert werden.

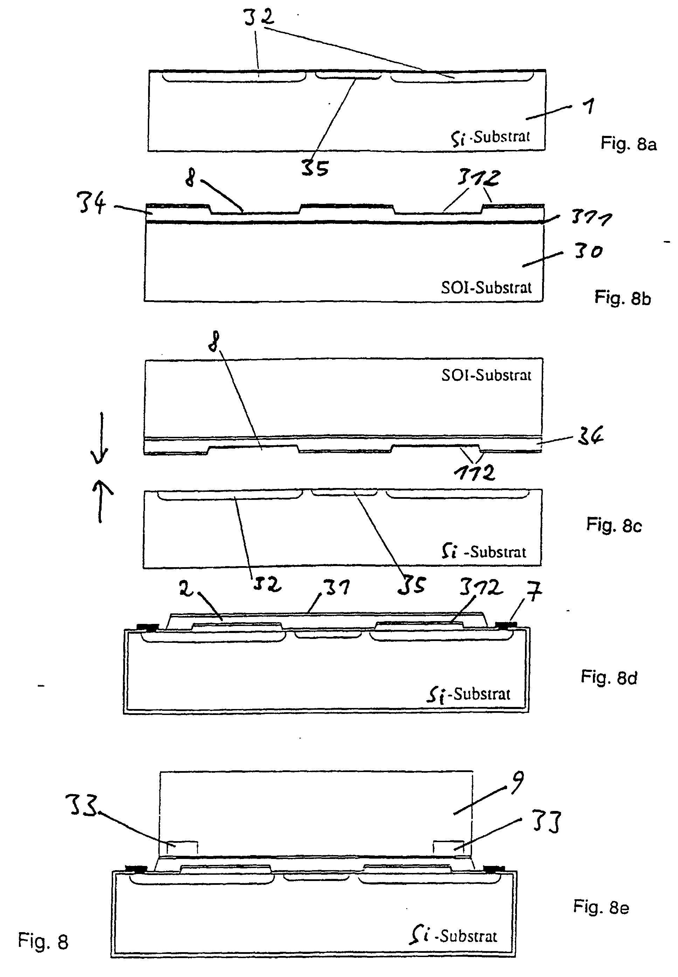

In Fig. 8 wird der bevorzugte Herstellungsprozess einer erfindungsgemäßen Pumpe dargestellt. Der Herstellungsprozess besteht aus den folgenden Herstellungsschritten:
1. In Teilprozeß 1 (Fig. 8a) werden auf einem n-leitenden Standard-Silizium-Substrat (1) die Antriebselektroden (32) (bevorzugt p+-dotiert mit n+-dotierten Kontaktbereichen (35)) des Pumpenaktuators durch ionenimplantation erzeugt.
2. Teilprozeß 2 (Fig. 8b) beinhaltet die Herstellung der Pumpenkavität (8) in einem Silicon On Insulator-Substrat (SOI-Substrat) (30). Die Kavität wird dabei in die SOI-Schicht (34) (Siliziumschicht über einer isolierenden Siiiziumoxid-Schicht (311)) geätzt. Die Oberfläche der SOI-Schicht wird anschließend oxidiert. Diese Oxidschicht (312) dient als Isolation zwischen der Membran und den implantierten Elektroden und ist für die Druckspannung der Membran verantwortlich. Die Siliziumschicht zwischen der Siliziumoxidschicht des SOI-Substrates und der Siliziumoxidschicht auf der Oberfläche bildet später die Membran.
3. Die beiden in den Teilprozessen 1 und 2 erstellten Substrate werden bei Umgebungsdruck aufeinander justiert (Fig. 8c). (In der Figur durch Pfeile angedeutet.) Dabei wird in das Volumen der Kavität Luft eingeschlossen. Beim, für das Bonden notwendigen Tempern wird der Sauerstoff der eingeschlossenen Luft verbraucht. Er reagiert mit den das Volumen einschließenden Oberflächen. Dadurch wird ein Unterdruck innerhalb der Kavität erzeugt.
4. In Teilprozeß 3 (Fig. 8d) werden die beiden Si-Substrate aufeinandergebondet (Silicon Fusion Bonding), das SOI-Substrat abgeschliffen bzw. abgeätzt, wodurch die Membran (2) entsteht und der Aktuator der Pumpe fertiggestellt. Dazu gehört das Öffnen der SOI-Schicht um die Kontaktbereiche der implantierten Elektroden freizulegen, das Ätzen der Kontaktlöcher und die Metallisierung der Kontakt-Pads (7). Um beim Bonden ein Ankleben der Menbran an den Deckel zu verhindern, ist im Membranbereich eine Anti-Haft-Beschichtung aufgebracht.
5. Teilprozeß 4 (Fig. 8e) definiert die Pumpmediumszuführungen (33) (Einlässe und Auslässe) im Glasdeckel (Glas-Substrat) (9), der nach dem justierten Übereinanderpositionieren anodisch auf das Substrat mit den Pumpenaktuatoren gebondet wird. Die bevorzugt unter Druckspannung stehende, spontan buckelnde Membran wird an den Deckel gepresst. Die Kanäle können z.B. nasschemisch geätzt werden, dann sind diese bevorzugt seitlich nach außen geführt (wie in der Fig. angedeutet) oder mittels Bohrungen verwirklicht werden.

### Bezugszeichenliste

- 1: Substrat
- 2: Membran
- 3: Angesteuerte Elektroden
- 4: Nicht angesteuerte Elektroden
- 5: nach oben gewölbte (gebuckelte) Membran
- 6: Nach unten gewölbte Membran
- 7: Kontakt-Pad
- 8: Einkerbung (Kavität)
- 9: Deckel
- 10, 101, 102: Auslass
- 11: Einlass
- 12: Pumpmedium
- 13: Verschluss 1
- 14: Verschluss 2
- 15: Kanal 2
- 16: Kanal 1
- 17: Antriebsmedium
- 21: getrennt ansteuerbare Elektroden (Elektrodenarray)
- 22: Verschluss
- 30: Silicon On Insolator-Substrat (SOI-Substrat)
- 31, 311, 312: Siliziumoxidschicht
- 32: Durch Ionenimplantation erzeugte Elektroden
- 33: Pumpmediumszuführungen
- 34: Silicon on Insolation Schicht (SOI-Schicht)
- 35: Kontaktbereich

## Patentansprüche

1. Mikromechanische Pumpe, mit
- einem Substrat (1) mit einer Kavität (8) auf dessen Oberseite,
- einer elektrisch leitfähigen und/oder leitfähig beschichteten, die Kavität (8) überspannenden Membran (2) auf der Oberseite des Substrats,
- einem Deckel (9) über dem mit der Membran überspannten Substrat,
- mehreren voneinander isolierten und mindestens teilweise getrennt ansteuerbaren, Elektroden (3, 4), auf dem Boden der Kavität,
**dadurch gekennzeichnet, dass** die Kavität linear endlos zusammenhängend ist, dass die Membran in den Bereichen der nicht angesteuerten Elektroden (4) wenigstens in Teilbereichen gegen die Fläche des Deckels dichtet (5), wogegen in den Bereichen der angesteuerten Elektroden (3) zwischen Deckel und Membran ein Spalt besteht indem die Membran in Richtung der Elektroden angezogen wird (6), und dass entweder der Spalt zwischen Deckel und Membran oder der Raum zwischen Substrat und Membran einen abgeschlossenen Hohlraum bildet und mit Antriebsmedium (17) gefüllt ist.

2. Mikromechanische Pumpe, mit
- einem Substrat (1) mit einer Kavität (8) auf dessen Oberseite,
- einer elektrisch leitfähigen und/oder leitfähig beschichteten, die Kavität (8) überspannenden Membran (2) auf der Oberseite des Substrats,
- einem Deckel (9) über dem mit der Membran überspannten Substrat,
- mehreren voneinander isolierten und mindestens teilweise getrennt ansteuerbaren,
Elektroden (3, 4), auf der, der Membran zugewandten Fläche des Deckels, **dadurch gekennzeichnet, dass** die Kavität linear endlos zusammenhängend ist, dass die Membran in den Bereichen der angesteuerten Elektroden (4) gegen die Fläche des Deckels dichtet (5), wogegen in den Bereichen der nicht angesteuerten Elektroden (3) zwischen Deckel und Membran wenigstens in Teilbereichen ein Spalt besteht und entweder der Spalt zwischen Deckel und Membran oder der Raum zwischen Substrat und Membran einen abgeschlossenen Hohlraum bildet und mit Antriebsmedium (17) gefüllt ist.

3. Mikromechanische Pumpe nach Anspruch 1 *oder 2*, **dadurch gekennzeichnet, dass** die Elektroden in Form und Größe der Querschnittsform der Kavität oder des Deckels, über der Kavität entsprechen.

4. Mikromechanische Pumpe nach einem der Ansprüche 1 bis 3, **dadurch gekennzeichnet, dass** die Kavität ringförmig ist.

5. Mikromechanische Pumpe nach einem der Ansprüche 1 bis 4, **dadurch gekennzeichnet, dass** die Kavität im Querschnitt die Form der nach unten ausgebuckelten Membran hat.

6. Mikromechanische Pumpe nach einem der Ansprüche 1 bis 5, **dadurch gekennzeichnet, dass** der Deckel und/oder das Substrat jeweils einen oder mehrere Zu-(11) und/oder Abflüsse (10) für das zu pumpende und/oder zu dosierende Medium (12) hat, welche zumindest teilweise unabhängig voneinander verschließbar oder zu öffnen sind.

7. Mikromechanische Pumpe nach einem der Ansprüche 1 bis 6, **dadurch, gekennzeichnet, dass** die Membran unter Druckspannung steht und/oder dass im mit Antriebsmedium gefüllten abgeschlossenen Hohlraum relativ zum Druck des Pumpmediums ein Unterdruck herrscht oder der abgeschlossene Hohlraum mit einer Flüssigkeit als Antriebsmedium gefüllt ist.

8. Mikromechanische Pumpe nach einem der Ansprüche 1 bis 7, **dadurch gekennzeichnet, dass** das Substrat und/oder die Membran und /oder der Deckel in Siliziumtechnologie gefertigt ist/sind und /oder die Elektroden in Silizium implantiert sind oder eine metallische Dünnschicht auf einem Isolator z. B. Glas, Kunststoff oder Keramik darstellen.

9. Mikromechanische Pumpe nach einem der Ansprüche 1 bis 8, **dadurch gekennzeichnet, dass** das als Antrieb der Pumpe wirkende elektrische Feld zwischen den Elektroden und der Membran nicht über dem Pumpmedium abfällt.

10. Mikromechanische Pumpe nach einem der Ansprüche 1 bis 9, **dadurch gekennzeichnet, dass** der Pumpvorgang elektronisch überwacht wird.

11. Verwendung der Mikromechanische Pumpe nach einem der Ansprüche 1 bis 10 zum Pumpen eines Pumpmediums **dadurch gekennzeichnet, dass** die Ansteuerung der Elektroden derart erfolgt, dass zwei Kanäle (15, 16), abgetrennt durch zwei Verschlüsse (13, 14), deren Breite so gewählt wird, dass es zu keinem Kurzschluß zwischen Ein- (11) und Auslaß (10) kommt, ausgebildet werden und die peristaltische Weiterbewegung dieser Verschlüsse derart erfolgt, dass wenn Verschluß 1 (13) zwischen Ein- und Auslaß positioniert ist, Verschluß 2 (14) in Richtung Auslaß bewegt wird, das Pumpmedium aus Kanal 1 (16) in den Auslaß verdrängt wird und gleichzeitig vom Pumpmedium aus dem Einlaß in Kanal 2 (15) angesaugt wird und wenn Verschluß 2 den Auslaß erreicht, Verschluß 1 synchron weiter geschoben wird, woraufhin die Verschlüsse die Funktion tauschen und ein neuer Pumpzyklus beginnt.

12. Verwendung der Mikromechanische Pumpe nach einem der Ansprüche 1 bis 10 zum Pumpen eines Pumpmediums **dadurch gekennzeichnet, dass** die Ansteuerung der Elektroden derart erfolgt, dass zwei Kanäle (15, 16), abgetrennt durch zwei Verschlüsse (13, 14), deren breite so gewählt wird, dass es zu keinem Kurzschluß zwischen Ein- (11) und Auslaß (10) kommt, ausgebildet werden und die peristaltische Weiterbewegung dieser Verschlüsse derart erfolgt, dass wenn Verschluß 1 (13) zwischen Ein- und Auslaß positioniert ist, Verschluß 2 (14) in Richtung Einlaß bewegt wird, das Pumpmedium aus Kanal 2 (15) in Richtung Einlaß verdrängt wird und gleichzeitig vom Pumpmedium aus dem Auslaß in Kanal 1 (16) angesaugt wird und wenn Verschluß 2 den Einlaß erreicht, Verschluß 1 synchron weiter geschoben wird, woraufhin die Verschlüsse die Funktion tauschen und ein neuer Pumpzyklus beginnt

13. Verwendung der Mikromechanische Pumpe nach den Ansprüchen 11 und 12 **dadurch gekennzeichnet, dass** die Pumprichtung während des Betriebes beliebig umgeschaltet wird.

14. Verwendung der Mikromechanische Pumpe nach einem der Ansprüche 1 bis 10 als Ventil **dadurch gekennzeichnet, dass** die Ansteuerung der Elektroden derart geschieht, dass durch gezieltes Öffnen und/oder Verschließen der Ein- und/oder Auslässe, ein Ventil mit jeweils einem oder mehreren Ein- und/oder Auslässen realisiert wird.

15. Verfahren zur Herstellung der Mikromechanische Pumpe nach einem der Ansprüche 1 bis 10 mit den Verfahrensschritten
- Bereitstellen eines ersten Substrats und Auf-/Einbringen von Antriebselektroden auf und/oder in dem Substrat,
- Bereitstellen eines SOI-Substrats und Ausformen einer linear endlos zusammenhängenden Kavität in der SOI-Schicht des SOI-Substrats,
- Aufbringen einer isolierenden Schicht auf der Oberfläche der SOI-Schicht,
- justiertes Verbinden der Oberfläche der auf die SOI-Schicht aufgebrachten isolierenden Schicht mit der Oberfläche des ersten Substrats auf welcher sich die Elektroden befinden,
- Herstellen einer Membran durch Dünnen des SOI-Substrates bis zur eingebetteten Isolatorschicht,
- Bereitstellen eines dritten Substrates als Deckel und Verbinden des Deckels mit der Oberfläche des gedünnten SOI-Substrates außerhalb des Membranbereichs.

16. Verfahren nach Anspruch 15 **dadurch gekennzeichnet, dass** die Antriebselektroden durch Ionenimplantation In das Substrat eingebracht werden.

17. Verfahren nach mindestens einem der Ansprüche 15 bis 16 **dadurch gekennzeichnet, dass** die auf die Oberfläche des SOI-Substrates, nach Ausformung der Kavität aufgebrachte isolierende Schicht aufoxidiert wird.

18. Verfahren nach mindestens einem der Ansprüche 15 bis 17 **dadurch gekennzeichnet, dass** die Verbindung der Substrate durch anodisches Bonden durchgeführt wird.

## Claims

1. Micromechanical pump, having
- a substrate (1) with a cavity (8) on its upper side,
- an electrically conductive and/or conductively coated diaphragm (2) spanning the cavity (8) on the upper side of the substrate,
- a cover (9) over the substrate spanned by the diaphragm,
- a plurality of mutually insulated and at least partially separately controllable electrodes (3, 4) on the bottom of the cavity,
**characterized in that** the cavity is linearly endlessly coherent, **in that**, in the regions of the non-driven electrodes (4), at least in subregions, the diaphragm seals (5) against the surface of the cover, whereas in the regions of the driven electrodes (3) there is a gap between cover and diaphragm, by the diaphragm being attracted (6) in the direction of the electrodes, and **in that** either the gap between cover and diaphragm or the space between substrate and diaphragm forms a sealed hollow space and is filled with drive medium (17).

2. Micromechanical pump, having
- a substrate (1) with a cavity (8) on its upper side,
- an electrically conductive and/or conductively coated diaphragm (2) spanning the cavity (8) on the upper side of the substrate,
- a cover (9) over the substrate spanned by the diaphragm,
- a plurality of mutually insulated and at least partially separately controllable electrodes (3, 4) on the surface of the cover facing the diaphragm,
**characterized in that** the cavity is linearly endlessly coherent, **in that**, in the regions of the driven electrodes (4), at least in subregions, the diaphragm seals (5) against the surface of the cover, whereas in the regions of the non-driven electrodes (3) there is a gap between cover and diaphragm, at least in subregions, and either the gap between cover and diaphragm or the space between substrate and diaphragm forms a sealed hollow space and is filled with drive medium (17).

3. Micromechanical pump according to Claim 1 or 2, **characterized in that** the electrodes correspond in shape and size to the cross-sectional shape of the cavity or of the cover over the cavity.

4. Micromechanical pump according to one of Claims 1 to 3, **characterized in that** the cavity is annular.

5. Micromechanical pump according to one of Claims 1 to 4, **characterized in that** the cavity has in cross-section the shape of the diaphragm bulged out downwards.

6. Micromechanical pump according to one of Claims 1 to 5, **characterized in that** the cover and/or the substrate in each case have one or more inlets (11) and/or outlets (10) for the medium (12) to be pumped and/or to be metered, which can be closed or are to be opened at least partly independently of one another.

7. Micromechanical pump according to one of Claims 1 to 6, **characterized in that** the diaphragm is under compressive stress and/or **in that**, in the sealed hollow space filled with drive medium, there prevails a negative pressure relative to the pressure of the pumped medium, or the sealed hollow space is filled with a liquid as drive medium.

8. Micromechanical pump according to one of Claims 1 to 7, **characterized in that** the substrate and/or the diaphragm and/or the cover is/are fabricated using silicon technology and/or the electrodes are implanted in silicon or represent a thin metallic layer on an insulator, e.g. glass, plastic or ceramic.

9. Micromechanical pump according to one of Claims 1 to 8, **characterized in that** the electric field acting as a drive for the pump does not fall off over the pumped medium between the electrodes and the diaphragm.

10. Micromechanical pump according to one of Claims 1 to 9, **characterized in that** the pumping operation is monitored electronically.

11. Use of the micromechanical pump according to one of Claims 1 to 10 for pumping a pumped medium, **characterized in that** the electrodes are driven in such a way that two channels (15, 16) are formed, separated by two closures (13, 14) whose width is chosen such that no short circuit occurs between inlet (11) and outlet (10), and the peristaltic onward movement of these closures is carried out in such a way that when closure 1 (13) is positioned between inlet and outlet, closure 2 (14) is moved in the direction of the outlet, the pumped medium from channel 1 (16) is displaced into the outlet, and at the same time the pumped medium from the inlet is sucked into channel 2 (15), and when closure 2 reaches the outlet, closure 1 is pushed onward synchronously, whereupon the closures interchange the function and a new pumping cycle begins.

12. Use of the micromechanical pump according to one of Claims 1 to 10 for pumping a pumped medium, **characterized in that** the electrodes are driven in such a way that two channels (15, 16) are formed, separated by two closures (13, 14) whose width is chosen such that no short circuit occurs between inlet (11) and outlet (10), and the peristaltic onward movement of these closures is carried out in such a way that when closure 1 (13) is positioned between inlet and outlet, closure 2 (14) is moved in the direction of the inlet, the pumped medium from channel 2 (15) is displaced in the direction of the inlet, and at the same time the pumped medium from the outlet is sucked into channel 1 (16), and when closure 2 reaches the inlet, closure 1 is pushed onward synchronously, whereupon the closures interchange the function and a new pumping cycle begins.

13. Use of the micromechanical pump according to Claims 11 and 12, **characterized in that** the pumping direction can be changed over as desired during operation.

14. Use of the micromechanical pump according to one of Claims 1 to 10 as a valve, **characterized in that** the electrodes are driven in such a way that, by means of specific opening and/or closing of the inlets and/or outlets, a valve with one or more inlets and/or outlets is implemented in each case.

15. Method of producing the micromechanical pump according to one of Claims 1 to 10, comprising the method steps
- providing a first substrate and applying/introducing drive electrodes onto and/or into the substrate,
- providing an SOI substrate and moulding an linearly endlessly coherent cavity in the SOI layer of the SOI substrate,
- applying an insulating layer to the surface of the SOI layer,
- adjusted connection of the surface of the insulating layer applied to the SOI layer to the surface of the first substrate on which the electrodes are located,
- producing a diaphragm by thinning the SOI substrate as far as the embedded insulating layer,
- providing a third substrate as cover and connecting the cover to the surface of the thinned SOI substrate outside the diaphragm area.

16. Method according to Claim 15, **characterized in that** the drive electrodes are introduced into the substrate by ion implantation.

17. Method according to at least one of Claims 15 to 16, **characterized in that** the insulating layer applied to the surface of the SOI substrate after the cavity has been moulded is oxidized.

18. Method according to at least one of Claims 15 to 17, **characterized in that** the connection between the substrates is made by means of anodic bonding.

## Revendications

1. Pompe micromécanique comprenant :
- un substrat (1) avec une cavité (8) dans son côté supérieur,
- une membrane (2) électroconductrice et/ou revêtue d'une couche conductrice, cette membrane étant tendue sur la cavité (8) sur le côté supérieur du substrat,
- un couvercle (9) pour le substrat sur lequel est tendue la membrane,
- plusieurs électrodes (3, 4) isolées les unes des autres et commandées au moins partiellement de manière séparée, ces électrodes étant prévues au fond de la cavité,
**caractérisée en ce que**
la cavité est reliée de manière linéaire, sans fin,
la membrane assure l'étanchéité (5) dans les zones des électrodes (4) non commandées, au moins dans des zones partielles contre la surface du couvercle, alors que dans les zones des électrodes commandées (3), entre le couvercle et la membrane, il y a un intervalle dans lequel la membrane est tirée en direction (6) des électrodes et
soit l'intervalle entre le couvercle et la membrane, soit l'espace entre le substrat et la membrane, forme une cavité fermée remplie de milieu d'entraînement (17).

2. Pompe micromécanique comportant :
- un substrat (1) avec une cavité (8) dans son côté supérieur,
- une membrane (2) électroconductrice et/ou revêtue de façon conductrice, et couvrant la membrane (8) sur le côté supérieur du substrat,
- un couvercle (9) au-dessus du substrat sur lequel est tendue la membrane,
- plusieurs électrodes (3, 4) isolées les unes des autres et qui peuvent être commandées au moins en partie de façon séparée, ces électrodes étant prévues sur le côté du couvercle tourné vers la membrane,
**caractérisée en ce que**
la cavité est reliée de façon sans fin, de manière linéaire,
la membrane assure l'étanchéité (5) dans les zones des électrodes commandées (4) contre la surface du couvercle, alors que dans les zones des électrodes (3) non commandées, au moins dans des zones partielles entre le couvercle et la membrane, il y a un intervalle, et soit cet intervalle entre le couvercle et la membrane soit l'espace entre le substrat et la membrane forme une cavité fermée remplie de fluide de travail (17).

3. Pompe micromécanique selon la revendication 1 ou 2,
**caractérisée en ce que**
les électrodes correspondent par leur forme et leur taille à la forme de la section de la cavité ou du couvercle sur la cavité.

4. Pompe micromécanique selon l'une des revendications 1 à 3,
**caractérisée en ce que**
la cavité est annulaire.

5. Pompe micromécanique selon l'une des revendications 1 à 4,
**caractérisée en ce que**
la cavité a en section la forme de la membrane déformée vers le bas.

6. Pompe micromécanique selon l'une des revendications 1 à 5,
**caractérisée en ce que**
le couvercle et/ou le substrat possède chaque fois une ou plusieurs arrivées et/ou sorties (10) pour le milieu à pomper et/ou à doser (12), et qui peuvent être ouvertes ou fermées au moins partiellement, indépendamment l'une de l'autre.

7. Pompe micromécanique selon l'une des revendications 1 à 6,
**caractérisée en ce que**
la membrane est en pression et/ou dans la cavité fermée remplie de fluide de travail, il règne une dépression par rapport à la pression du milieu à pomper, ou la cavité fermée, est remplie d'un fluide comme milieu de travail.

8. Pompe micromécanique selon l'une des revendications 1 à 7,
**caractérisée en ce que**
le substrat et/ou la membrane et/ou le couvercle sont réalisés en technique du silicium et/ou les électrodes sont implantées dans le silicium ou représentent une mince couche métallique sur l'isolateur, par exemple du verre, de la matière plastique ou de la céramique.

9. Pompe micromécanique selon l'une des revendications 1 à 8,
**caractérisée en ce que**
le champ électrique assurant l'entraînement de la pompe chute entre les électrodes et la membrane mais sans passer par le milieu de la pompe.

10. Pompe micromécanique selon l'une des revendications 1 à 9,
**caractérisée en ce que**
l'opération de pompage est surveillée de manière électronique.

11. Utilisation de la pompe micromécanique selon l'une des revendications 1 à 10 pour pomper un milieu,
**caractérisée en ce que**
la commande des électrodes est faite pour que deux canaux (15, 16), séparés par deux fermetures (13, 14), ait une largeur choisie pour ne pas avoir de court-circuit entre l'entrée (11) et la sortie (10) et la poursuite du mouvement péristaltique de ces fermetures se fait pour que lorsque la fermeture 1 (13) est placée entre l'entrée et la sortie, la fermeture 2 (14) se déplace en direction de la sortie, le milieu à pomper est refoulé du canal 1 (16) dans la sortie et en même temps du milieu à pomper est aspiré de l'entrée dans le canal 2 (15), et lorsque la fermeture (2) atteint la sortie, la fermeture (1) continue d'avancer de manière synchrone puis ces fermetures échangent leur rôle et un nouveau cycle de pompage commence.

12. Application de la pompe micromécanique selon l'une des revendications 1 à 10 pour pomper un milieu,
**caractérisée en ce que**
la commande des électrodes se fait pour que deux canaux (15, 16) séparés par deux fermetures (13, 14) dont la largeur est choisie, ne créent pas de court-circuit entre l'entrée (11) et la sortie (10), et la poursuite du mouvement péristaltique de ces fermetures se fait de sorte que lorsque la fermeture 1 (13) est positionnée entre l'entrée et la sortie, la fermeture 2 (14) se déplace en direction de l'entrée, le milieu à pomper est refoulé du canal 2 (15) en direction de l'entrée et en même temps du milieu de pompage est aspiré de la sortie du canal 1 (16), et si la fermeture 2 atteint l'entrée, la fermeture 1 continue d'avancer de manière synchrone puis les fermetures changent de rôle et un nouveau cycle de pompage commence.

13. Application de la pompe micromécanique selon les revendications 11 et 12,
**caractérisée en ce que**
la direction de pompage est commutée de façon quelconque pendant le fonctionnement.

14. Utilisation de la pompe micromécanique selon l'une des revendications 1 à 10 comme soupape,
**caractérisée en ce que**
la commande des électrodes est telle que l'ouverture et/ou la fermeture précise des entrées et/ou sorties réalise une soupape ayant chaque fois une ou plusieurs entrées et/ou sorties.

15. Procédé de réalisation de la pompe micromécanique selon l'une des revendications 1 à 10 comprenant les étapes de procédé suivantes :
- on fournit un premier substrat et on applique/installe des électrodes d'entraînement sur et/ou dans le substrat,
- on fournit un substrat SOI et on forme une cavité reliée sans fin, linéaire, dans la couche SOI du substrat SOI,
- on applique une couche isolante à la surface de la couche SOI,
- on ajuste la liaison de la surface de la couche SOI appliquée, isolante, avec la surface du premier substrat sur lequel se trouvent les électrodes,
- on réalise une membrane en amincissant le substrat SOI jusqu'à une couche d'isolant intégrée,
- on fournit un troisième substrat comme couvercle et on relie le couvercle à la surface du substrat SOI aminci, en dehors de la zone de membrane.

16. Procédé selon la revendication 15,
**caractérisé en ce qu'**
on introduit les électrodes d'entraînement dans le substrat par implantation ionique.

17. Procédé selon au moins l'une des revendications 15 à 16,
**caractérisé en ce qu'**
après démoulage de la cavité on oxyde une couche d'isolation appliquée à la surface du substrat SOI.

18. Procédé selon au moins l'une des revendications 15 à 17,
**caractérisé en ce qu'**
on relie le substrat par une liaison anodique.
